(19) Europäisches Patentamt / European Patent Office / Office européen des brevets

(11) **EP 2 904 651 B1**

(12) **FASCICULE DE BREVET EUROPEEN**

(45) Date de publication et mention de la délivrance du brevet:
**04.12.2019 Bulletin 2019/49**

(51) Int Cl.:
**H01L 51/44** *(2006.01)*    **H01L 51/52** *(2006.01)*

(21) Numéro de dépôt: **13785825.4**

(22) Date de dépôt: **02.10.2013**

(86) Numéro de dépôt international:
**PCT/EP2013/070591**

(87) Numéro de publication internationale:
**WO 2014/053572 (10.04.2014 Gazette 2014/15)**

(54) **ELECTRODE TRANSPARENTE CONDUCTRICE ET PROCÉDÉ DE FABRICATION ASSOCIÉ**

TRANSPARENTE LEITENDE ELEKTRODE UND ZUGEHÖRIGES HERSTELLUNGSVERFAHREN

TRANSPARENT CONDUCTIVE ELECTRODE AND ASSOCIATED PRODUCTION METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **03.10.2012 FR 1259359**

(43) Date de publication de la demande:
**12.08.2015 Bulletin 2015/33**

(73) Titulaire: **Hutchinson**
**75008 Paris (FR)**

(72) Inventeurs:
- **JACQUEMOND, Jérémie**
  **F-45200 Montargis (FR)**
- **ROGER, Stéphane**
  **F-45700 Saint Maurice sur Fessard (FR)**
- **DUFOUR, Bruno**
  **F-77430 Champagne sur Seine (FR)**
- **SONNTAG, Philippe**
  **F-77210 Avon (FR)**

(74) Mandataire: **Croonenbroek, Thomas Jakob et al**
**Innovincia**
**11, avenue des Tilleuls**
**74200 Thonon-les-Bains (FR)**

(56) Documents cités:
**EP-A1- 2 461 649      WO-A1-2011/077804**
**WO-A1-2012/124647    WO-A2-01/06306**
**US-A1- 2008 237 547   US-A1- 2012 138 913**

EP 2 904 651 B1

**Description**

La présente invention concerne une électrode transparente conductrice ainsi que son procédé de fabrication, dans le domaine général de l'électronique organique.

Les électrodes transparentes conductrices présentant à la fois une transmittance et des propriétés de conductivité électrique élevées font actuellement l'objet de développements considérables dans le domaine des équipements électroniques, ce type d'électrodes étant de plus en plus utilisé pour des dispositifs tels que les cellules photovoltaïques, les écrans à cristaux liquides, les diodes électroluminescentes organiques (OLED) ou les diodes électroluminescentes polymériques (PLED), ainsi que les écrans tactiles.

Il existe à l'heure actuelle un besoin important dans le domaine de l'électronique et en particulier de l'électronique organique, d'électrodes possédant à la fois une bonne transmittance, supérieure à 75%, et une forte conductivité (résistance de surface au moins inférieure à 1000 $\Omega/\square$). Pour des applications telles que citées plus haut, il est nécessaire d'avoir une surface de faible rugosité, inférieure à 20 nm et un faible coefficient de haze.

Afin d'obtenir des électrodes transparentes conductrices ayant une transmittance et des propriétés de conductivité électrique élevées, il est connu d'avoir une électrode transparente conductrice multicouche comportant dans un premier temps une couche substrat sur laquelle sont déposés une couche d'adhésion, un réseau percolant de nanofilaments métalliques et une couche d'encapsulation en polymère conducteur comme par exemple un mélange poly(3,4-éthylènedioxythiophène) (PEDOT) et poly(styrène sulfonate) de sodium (PSS), formant ce que l'on appel le PEDOT:PSS.

La demande US2009/129004 décrit une électrode transparente multicouche permettant d'atteindre une bonne transmittance et une faible résistivité de surface. Néanmoins, une telle électrode comporte une architecture complexe, avec une couche substrat, une couche d'adhésion, une couche constituée de nanofilaments métalliques, une couche conductrice constituée de nanotubes de carbone, d'un polymère conducteur et d'un élastomère. Cette addition de couches entraîne un coût important pour le procédé.

De plus, le matériau est également hétérogène, ce qui entraîne une rugosité et un coefficient de haze élevés. Enfin, la couche conductrice est à base de nanotubes de carbone, qui posent des problèmes de dispersion, et donc entraîne la présence de défauts optiques.

Il est donc désirable de développer une électrode transparente conductrice comportant moins de couches, et ne comportant pas de nanotubes de carbone.

Il existe une approche moins coûteuse, consistant en un simple mélange d'un polymère conducteur, tel que le PEDOT/PSS avec un polymère souple, tel que décrit dans Sun et al., Progress in Organic Coatings, 59 (2007), 115-121 et Yin et al., Journal of Materials Chemistry, 2012, 22, 3800. Ces articles montrent néanmoins par microscopie que les mélanges ne sont pas homogènes, il y a une séparation de phase entre le polymère conducteur et le polymère souple. De ce fait, ces composites sont constitués d'un réseau continu de polymère conducteur dans une matrice de polymère souple. Néanmoins, les composites obtenus par cette méthode décrite dans ces articles présentent un coefficient de haze élevé et une forte rugosité de surface.

Par ailleurs, on connaît des documents WO 2011/077804, EP 2461649, WO 2012/124647, US 2012/138913, US 2008/237547, et WO 01/06306 des électrodes transparentes conductrices multicouches. Cependant, de telles électrodes peuvent encore être améliorées.

Un des buts de l'invention est donc de remédier au moins partiellement aux inconvénients de l'art antérieur et de proposer une électrode transparente conductrice multicouche ayant une faible rugosité ainsi qu'un faible coefficient de haze, ainsi que son procédé de fabrication.

La présente invention concerne donc une électrode transparente conductrice multicouche, comportant :

- une couche substrat,
- une couche conductrice comprenant au moins un polymère conducteur polythiophène éventuellement substitué, et

la couche conductrice étant en contact direct avec la couche substrat, le polymère conducteur polythiophène éventuellement substitué présente une proportion en poids comprise entre 10 et 65 %, et

la couche conductrice comportant également au moins un polymère adhésif hydrophobe dans une proportion en poids comprise entre 20 et 90% et ayant une compatibilité chimique avec le polymère conducteur polythiophène éventuellement substitué, de sorte que ladite électrode transparente conductrice multicouche ait un coefficient de haze inférieur ou égale à 3%.

L'électrode transparente conductrice multicouche selon l'invention répond aux exigences et propriétés suivantes :

- une résistance électrique de surface R, inférieure ou égale à 1000 $\Omega/\square$ et supérieure ou égale à 50 $\Omega/\square$,
- une transmittance moyenne $T_{moy}$ dans le spectre du visible, supérieure ou égale à 75%,
- un coefficient de haze inférieur ou égale à 3%,

- une rugosité inférieure à 20 nm,
- une adhésion au substrat directe,
- une absence de déphasage entre les composants de la couche conductrice.

Selon un aspect de l'invention, la couche conductrice comporte également au moins un polymère additionnel.
Selon un autre aspect de l'invention, le polymère additionnel est du polyvinylpyrrolidone.
Selon un autre aspect de l'invention, l'électrode transparente conductrice multicouche présente une transmittance moyenne sur le spectre visible supérieure ou égale à 75 %.
Selon un autre aspect de l'invention, l'électrode transparente conductrice multicouche présente une rugosité inférieure à 20 nm.
Selon un autre aspect de l'invention, l'électrode transparente conductrice multicouche présente une résistance de surface inférieure ou égale à 1000 $\Omega/\square$ et supérieure ou égale à 50 $\Omega/\square$.
Selon un autre aspect de l'invention, le substrat est choisi parmi, le verre et les polymères flexibles transparents.
Selon un autre aspect de l'invention, le polymère adhésif comporte des fonctions ester en chaine latérale.
Selon un autre aspect de l'invention, le polymère adhésif hydrophobe est choisi parmi les polyacétates de vinyle et les polyesters acryliques.
L'invention concerne également un procédé de fabrication d'une électrode transparente conductrice multicouche, comportant les étapes suivantes :

- une étape de réalisation d'une composition formant la couche conductrice comportant :

  ◦ au moins un polymère conducteur polythiophène éventuellement substitué présentant une proportion en poids comprise entre 10 et 65 %,
  ◦ au moins un polymère adhésif hydrophobe présentant une proportion en poids entre 20 et 90% et ayant une compatibilité chimique avec le polymère conducteur polythiophène éventuellement substitué de sorte que ladite électrode transparente conductrice multicouche ait un coefficient de haze inférieur ou égale à 3%,

- une étape d'application et de séchage de la composition formant la couche conductrice directement sur une couche substrat,
- une étape de réticulation thermique

de la couche conductrice.
Selon un aspect du procédé selon l'invention, la composition formant la couche conductrice comporte en outre au moins un polymère additionnel.
Selon un autre aspect du procédé selon l'invention, le polymère additionnel est du polyvinylpyrrolidone.
Selon un autre aspect du procédé selon l'invention, substrat de la couche substrat est choisi parmi, le verre et les polymères flexibles transparents.
Selon un autre aspect du procédé selon l'invention, le polymère adhésif comporte des fonctions ester en chaine latérale.
Selon un autre aspect du procédé selon l'invention, le polymère adhésif est choisi parmi les polyacétates de vinyle et les polyesters acryliques.
D'autres caractéristiques et avantages de l'invention apparaîtront plus clairement à la lecture de la description suivante, donnée à titre d'exemple illustratif et non limitatif, et des dessins annexés parmi lesquels :

- la figure 1 montre une représentation schématique en coupe des différentes couches de l'électrode transparente conductrice multicouche,
- la figure 2 montre un organigramme des différentes étapes du procédé de fabrication selon l'invention,
- la figure 3A montre une photographie au microscope électronique en vue de dessus d'une électrode transparente conductrice multicouche ne présentant pas de déphasage entre les polymères de la couche conductrice, et
- la figure 3B montre une photographie au microscope électronique en vue de dessus d'une électrode transparente conductrice multicouche présentant un déphasage entre les polymères de la couche conductrice.

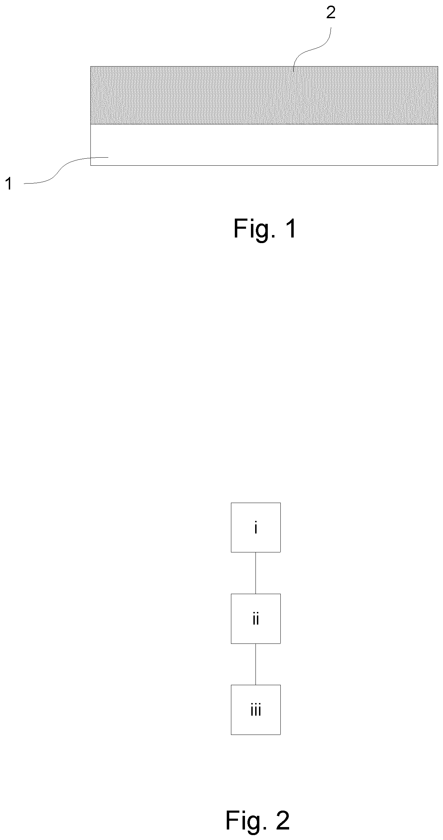

La présente invention concerne une électrode transparente conductrice multicouche, illustrée sur la figure 1. Ce type d'électrode ayant de préférence une épaisseur comprise entre 0.05um et 20$\mu$m. Ladite électrode transparente conductrice multicouche comporte :

- une couche substrat 1, et
- une couche conductrice 2 en contact direct avec la couche substrat 1.

Afin de préserver le caractère transparent de l'électrode, la couche substrat 1 doit être transparente. Elle peut être flexible ou rigide et avantageusement choisi parmi le verre dans le cas où il doit être rigide, ou alors choisi parmi les polymères flexibles transparents tels que le polyéthylène téréphtalate (PET), le polyéthylène naphtalate (PEN), le polyéthersulfone (PES), le polycarbonate (PC), le polysulfone (PSU), les résines phénoliques, les résines époxys, les résines polyesters, les résines polyimides, les résines polyétheresters, les résines polyétheramides, le polyvinyl(acétate), le nitrate de cellulose, l'acétate de cellulose, le polystyrène, les polyoléfines, le polyamide, les polyuréthanes aliphatiques, le polyacrylonitrile, le polytétrafluoroéthylène (PTFS), le polyméthylméthacrylate (PMMA), le polyarylate, les polyétherimides, les polyéthers cétones (PEK), les polyéthers éthers cétones (PEEK) et le polyfluorure de vinylidène (PVDF), les polymères flexibles les plus préférés étant le polyéthylène téréphtalate (PET), le polyéthylène naphtalate (PEN) et le polyéthersuifone (PES).

La couche conductrice 2 comporte :

(a) au moins un polymère conducteur polythiophène éventuellement substitué présentant une proportion en poids comprise entre 10 et 65 %,

(b) au moins un polymère adhésif hydrophobe présentant une proportion en poids entre 20 et 90% et ayant une compatibilité chimique avec le polymère conducteur polythiophène éventuellement substitué, de sorte que ladite électrode transparente conductrice multicouche a un coefficient de haze inférieur ou égale à 3%. Le fait que le polymère adhésif soit hydrophobe permet justement une bonne compatibilité chimique le polymère conducteur polythiophène éventuellement substitué car ce dernier est également hydrophobe.

La couche conductrice 2 peut également comporter :

(c) au moins un polymère additionnel.

Le polymère conducteur (a) est un polythiophène, ce dernier étant un des polymères les plus stables thermiquement et électroniquement. Un polymère conducteur préféré est le poly(3,4-éthylènedioxythiophène)-poly(styrènesulfonate) (PEDOT: PSS), ce dernier étant stable à la lumière et à la chaleur, facile à disperser dans l'eau, et ne présentant pas d'inconvénients environnementaux.

Le polymère adhésif (b) a une bonne compatibilité chimique avec le polymère conducteur polythiophène éventuellement substitué de sorte que l'électrode transparente conductrice multicouche ait un coefficient de haze inférieur ou égale à 3%. Pour cela, le polymère adhésif (b) peut avantageusement comporter des fonctions ester en chaine latérale et plus particulièrement, ledit polymère adhésif (b) peut être choisi parmi les polyacétates de vinyle et les polyesters acryliques.

Le polymère additionnel (c) est choisi parmi les alcools polyvinyliques (PVOH), les pyrrolidones polyvinyliques (PVP), les polyéthylènes glycols ou encore les éthers et esters de cellulose ou autres polysaccarides. Ce polymère additionnel (c) est un viscosifiant et aide à la formation d'un film de bonne qualité lors de l'application de la couche conductrice 2 sur la couche substrat 1.

La couche conductrice 2 comprend chacun des constituants (a), (b), et (c) dans les proportions en poids (pour un total de 100% en poids) suivantes:

(a) de 10 à 65% en poids d'au moins un polymère conducteur polythiophène éventuellement substitué,

(b) de 20 à 90% en poids d'au moins un polymère adhésif ou copolymère adhésif,

(c) et de 0 à 15% en poids d'au moins un polymère additionnel.

L'électrode transparente conductrice multicouche selon l'invention comporte ainsi :

- une résistance électrique de surface R, inférieure ou égale à 1000 $\Omega/\square$ et supérieure ou égale à 50 $\Omega/\square$,
- une transmittance moyenne $T_{moy}$ dans le spectre du visible, supérieure ou égale à 75%,
- un coefficient de haze inférieur ou égale à 3%,
- une rugosité inférieure à 20 nm,
- une adhésion directe de la couche conductrice 2 sur la couche substrat 1,
- une absence de déphasage entre les composants de la couche conductrice 2, et
- une absence de réseau de nanofilaments métalliques.

La présente invention concerne également un procédé de fabrication d'une électrode transparente conductrice multicouche, comportant les étapes suivantes :

Les étapes du procédé de fabrication sont illustrées sur l'organigramme de la figure 2.

i) réalisation d'une composition formant la couche conductrice 2.

Lors de cette étape i, est réalisée une composition formant la couche conductrice 2.

La composition formant la couche conductrice 2 est obtenue par mélange :

(a) d'au moins un polymère conducteur polythiophène éventuellement substitué, et
(b) d'au moins un polymère adhésif ou copolymère adhésif hydrophobe.
La couche conductrice 2 peut également comporter :
(c) au moins un polymère additionnel.

La réalisation de la composition formant la couche conductrice peut comporter des étapes successives de mélanges et d'agitation, par exemple au moyen d'agitateur magnétique comme illustré dans les exemples de composition des exemples A et B décrits plus bas dans la partie expérimentale.

Le polymère conducteur (a) est un polythiophène, ce dernier étant un des polymères les plus stables thermiquement et électroniquement. Un polymère conducteur préféré est le poly(3,4-éthylènedioxythiophène)-poly(styrènesulfonate) (PEDOT: PSS), ce dernier étant stable à la lumière et à la chaleur, facile à disperser dans l'eau, et ne présentant pas d'inconvénients environnementaux.

Le polymère conducteur (a) peut se présenter sous la forme d'une dispersion ou d'une suspension dans l'eau et/ou dans un solvant, ledit solvant étant de préférence un solvant organique polaire choisi parmi le diméthylsulfoxyde (DMSO), le N-méthyl-2-pyrrolidone (NMP), l'éthylène glycol, le tétrahydrofuranne (THF), le diméthylacétate (DMAc), le diméthylformamide (DMF), le polymère adhésif hydrophobe (b) étant de préférence en dispersion ou en suspension dans de l'eau, du diméthylsulfoxyde (DMSO) ou de l'éthylène glycol.

Le polymère adhésif hydrophobe (b) doit avoir une bonne compatibilité chimique avec le polymère conducteur polythiophène éventuellement substitué de sorte que l'électrode transparente conductrice multicouche ait un coefficient de haze inférieur ou égale à 3%. Pour cela, le polymère adhésif hydrophobe (b) peut avantageusement comporter des fonctions ester en chaine latérale et plus particulièrement, ledit polymère adhésif hydrophobe (b) peut être choisi parmi les polyacétates de vinyle et les polyesters acryliques.

Le polymère additionnel (c) est choisi parmi les alcools polyvinyliques (PVOH), les pyrrolidones polyvinyliques (PVP), les polyéthylènes glycols ou encore les éthers et esters de cellulose ou autres polysaccharides. Ce polymère additionnel (c) est un viscosifiant et aide à la formation d'un film de bonne qualité lors de l'application de la couche conductrice 2 sur la couche substrat 1.

Le polymère additionnel (c) peut se présenter sous la forme d'une dispersion ou d'une suspension dans l'eau et/ou dans un solvant, ledit solvant étant de préférence un solvant organique choisi parmi le diméthylsulfoxyde (DMSO), le N-méthyl-2-pyrrolidone (NMP), l'éthylène glycol, le tétrahydrofuranne (THF), le diméthylacétate (DMAc) ou le diméthylformamide (DMF).

ii) application et séchage de la couche conductrice 2 sur une couche substrat 1.

Lors de cette étape ii, la composition formant la couche conductrice 2 est appliquée directement sur une couche substrat 1, selon n'importe quelle méthode connue de l'homme de l'art, les techniques les plus utilisées étant le spray coating (recouvrement par pulvérisation), le dépôt au jet d'encre, le dépôt au trempé, le dépôt au tire-film, le dépôt au spin-coater (tournette de dépôt), le dépôt par imprégnation, le dépôt au slot-die (fente d'enduction), le dépôt à la racle, ou la flexogravure.

Afin de préserver le caractère transparent de l'électrode, ce substrat 1 doit être transparent. Il peut être flexible ou rigide et avantageusement choisi parmi le verre dans le cas où il doit être rigide, ou alors choisi parmi les polymères flexibles transparents tels que le polyéthylène téréphtalate (PET), le polyéthylène naphtalate (PEN), le polyéthersulfone (PES), le polycarbonate (PC), le polysulfone (PSU), les résines phénoliques, les résines époxys, les résines polyesters, les résines polyimides, les résines polyétheresters, les résines polyétheramides, le polyvinyl(acétate), le nitrate de cellulose, l'acétate de cellulose, le polystyrène, les polyoléfines, le polyamide, les polyuréthanes aliphatiques, le polyacrylonitrile, le polytétrafluoroéthylène (PTFS), le polyméthylméthacrylate (PMMA), le polyarylate, les polyétherimides, les polyéthers cétones (PEK), les polyéthers éthers cétones (PEEK) et le polyfluorure de vinylidène (PVDF), les polymères flexibles les plus préférés étant le polyéthylène téréphtalate (PET), le polyéthylène naphtalate (PEN) et le polyéthersuifone (PES).

Après l'application de la couche conductrice 2, est réalisé un séchage de cette dernière. Ce séchage peut être réalisé à une température comprise entre 20 et 50° C sous air pendant 1 à 45 minutes

iii) Réticulation de la couche conductrice 2.

Lors de cette étape iii, une réticulation de la couche conductrice 2 est par exemple réalisée par vulcanisation à une température de 150°c pendant une durée de 5 minutes.

Les solvants de la composition formant la couche conductrice 2 sont évaporés lors de cette réticulation.

La couche conductrice 2, après réticulation, comprend chacun des constituants (a), (b), et (c) dans les proportions en poids (pour un total de 100% en poids) suivantes:

(a) de 10 à 65% en poids d'au moins un polymère conducteur polythiophène éventuellement substitué,
(b) de 20 à 90% en poids d'au moins un polymère adhésif ou copolymère adhésif hydrophobe,
(c) de 0 à 15% en poids d'au moins une dissolution de polymère additionnel.

Les résultats expérimentaux suivants, montrent des valeurs obtenues par une électrode transparente conductrice multicouche selon l'invention, pour des paramètres essentiels tels que la transmittance à la longueur d'onde de 550nm $T_{550}$, la transmittance moyenne $T_{moy}$, la résistance électrique de surface R, la rugosité de surface, le coefficient de haze, ainsi que la présence ou non de déphasage entre les composants de la couche conductrice 2.

Ces résultats sont mis en relation avec des valeurs obtenues pour des électrodes transparentes conductrices multicouche issues d'un contre exemple utilisant un polymère adhésif n'ayant pas de compatibilité chimique avec le polymère conducteur.

1) Méthodologie des mesures:

Mesure de la transmittance totale.

La transmittance totale, c'est-à-dire l'intensité lumineuse traversant le film sur le spectre du visible, est mesurée sur des éprouvettes 50 x 50 mm à l'aide d'un spectrophotomètre Perkin Elmer Lambda 35 © sur un spectre UV-visible [300 nm - 900 nm].

Deux valeurs de transmittance sont relevées:

- la valeur de transmittance à 550 nm $T_{550}$, et
- la valeur moyenne de transmittance $T_{moy}$ sur tout le spectre du visible, cette valeur correspondant à la valeur moyenne des transmittances sur le spectre du visible. Cette valeur est mesurée tous les 10 nm.

Mesure de la résistance électrique de surface.

La résistance électrique de surface (en $\Omega/\square$) peut être définie par la formule suivante:

$$R = \frac{\rho}{e} = \frac{1}{\sigma.e}$$

e : épaisseur de la couche conductrice (en cm),
$\sigma$ : conductivité de la couche (en S/cm) ($\sigma = 1/p$),
$\rho$ : résistivité de la couche (en $\Omega$.cm).

La résistance électrique de surface est mesurée sur des éprouvettes 20 x 20 mm à l'aide d'un ohmètre Keithley 2400 SourceMeter © et des deux pointes pour faires les mesures. Des contacts en or sont préalablement déposés sur l'électrode par CVD, afin de faciliter les mesures.

Mesure du coefficient de haze

Le coefficient de haze, exprimé en pourcentage, est mesuré sur des éprouvettes 50x50 mm à l'aide d'un spectromètre Perkin Elmer Lambda 35 © muni d'une sphère d'intégration. Ce coefficient peut être défini par la formule suivante :

$$H = T_d \, / \, T_{moy} *100$$

$T_{moy}$ : La valeur moyenne de la transmittance direct entre 400 et 800 nm.
$T_d$ : La valeur de la transmittance diffusé entre 400 et 800 nm. Cette transmittance est calculé comme la différence entre les transmittance moyenne avec et sans sphère d'intégration.

Plus ce rapport est faible, moins l'échantillon diffuse de lumière et plus une image observée à travers l'électrode transparente semblera nette.

Déphasage entre les différents polymères.

L'évaluation du déphasage entre le polymère conducteur (a) et le polymère adhésif (b), dans l'électrode transparente est réalisée sur des éprouvettes 50x50 mm à l'aide d'un microscope optique Olympus BX51 au grossissement (x100, x200, x400). Chaque éprouvette est observée au microscope aux différents grossissements dans son intégralité.

Mesure de la rugosité de surface de l'électrode transparente.

La rugosité de surface de l'électrode transparente est réalisée sur des éprouvettes 50x50 mm à l'aide d'un appareil de microscopie à force atomique AFM (Atomic Force Microscopy). Le microscope à force atomique balaye la surface de l'échantillon avec une pointe très fine. L'analyse des déplacements de cette pointe permet de définir la topographie de la surface de l'échantillon. On calcul ensuite la rugosité quadratique moyenne (Rq) exprimé en nm.

2) Composition des exemples :

Légendes:

| DMSO | Diméthylsulfoxyde |
|---|---|
| PEDOT : PSS | poly(3,4-éthylènedioxythiophène)-poly(styrènesulfonate) |
| Emultex 378 © | Polyacétate de vinyle |
| Revacryl 272 © | Copolymère d'acrylonitrile - acrylique ester |
| Revacryl 5467 © | Polyester acrylique |
| PVP | Polyvinylpyrrolidone |

Exemple A :

3.3 g de DMSO sont ajoutés à 20 mg de PVP (dilué à 20% dans de l'eau déionizée) puis agités 10 minutes à l'aide d'un agitateur magnétique à 600 rpm. 3 g de PEDOT : PSS à 1.2% d'extrait sec sont ensuite additionnés au mélange précédent. Après 10 minutes agitation supplémentaire, 1.6g d'Emultex 378 © (dilué à 10% dans de l'eau déionizée, extrait sec 4.5%, Tg = 40 °C) sont ajoutés à la solution et agités pendant 30 minutes.
Le mélange obtenu est alors déposé à l'aide d'une racle sur une couche substrat en verre. Ce dernier est vulcanisé à 150 °C pendant une durée de 5 minutes.

Exemple B :

3.3 g de DMSO sont ajoutés à 20 mg de PVP (dilué à 20% dans de l'eau déionizée) puis agités 10 minutes à l'aide d'un agitateur magnétique à 600 rpm. 3 g de PEDOT : PSS à 1.2% d'extrait sec sont ensuite additionnés au mélange précédent. Après 10 minutes agitation supplémentaire, 2.4 g de Revacryl 5467 © (dilué à 10% dans de l'eau déionizée, extrait sec 3.0%) sont ajoutés à la solution et agités pendant 30 minutes.
Le mélange obtenu est alors déposé à l'aide d'une racle sur une couche substrat en verre. Ce dernier est vulcanisé à 150 °C pendant une durée de 5 minutes.

Contre-exemple :

3.3 g de DMSO sont ajoutés à 20 mg de PVP (dilué à 20% dans de l'eau déionizée) puis agités 10 minutes à l'aide d'un agitateur magnétique à 600 rpm. 3 g de PEDOT : PSS à 1.2% d'extrait sec sont ensuite additionnés au mélange précédent. Après 10 minutes agitation supplémentaire, 1.6g de Revacryl 272 © (dilué à 10% dans de l'eau déionizée, extrait sec 4.5%, Tg = -30 °C) sont ajoutés à la solution et agités pendant 30 minutes.

Le mélange obtenu est alors déposé à l'aide d'une racle sur une couche substrat en verre. Ce dernier est vulcanisé à 150 °C pendant une durée de 5 minutes.

3) _Résultats_ :

|  | Exemple A | Exemple B | Contre - Exemple |
|---|---|---|---|
| $T_{moy}$ (%) | 84.8 | 86.0 | 82.6 |
| Coefficient de haze | 1.6 | 2.2 | 5.7 |
| Résistance de surface ($\Omega/\square$) | 203 | 205 | 201 |
| Rugosité : Rq (nm) | 12 | 9 | 28 |
| Déphasage observé au microscope optique | Non | Non | Oui |

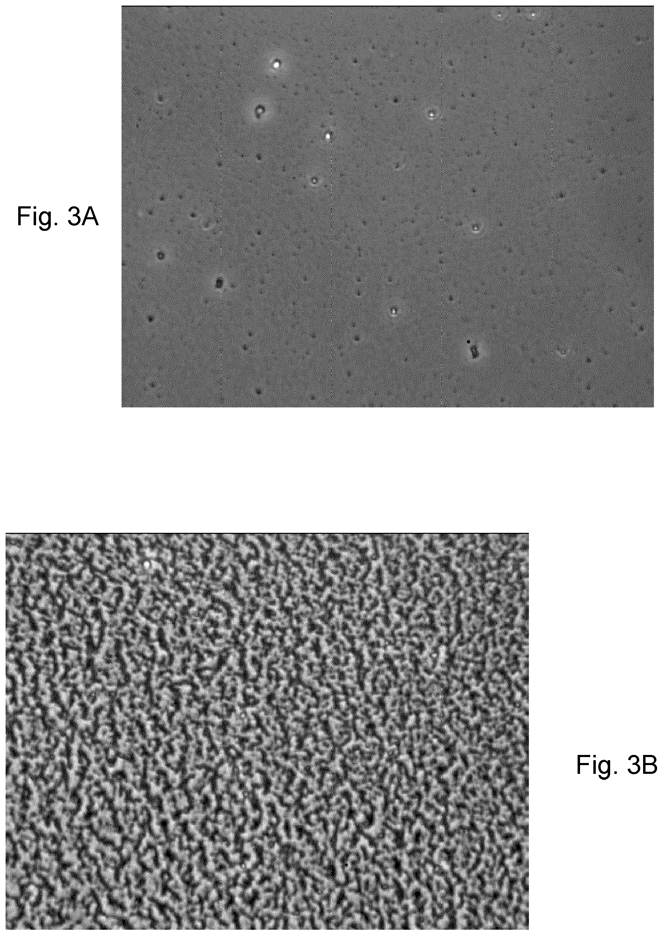

La figure 3A montre plus particulièrement une photographie microscopique de la surface de l'électrode transparente conductrice multicouche de l'exemple A, ne présentant pas de déphasage entre le polymère conducteur (a) et le polymère adhésif (b).

La figure 3A montre plus particulièrement une photographie microscopique de la surface de l'électrode transparente conductrice multicouche du contre exemple, présentant un déphasage entre le polymère conducteur (a) et le polymère adhésif (b), réduisant de fait le coefficient de haze et augmentant la rugosité.

La présence d'un polymère adhésif (b) directement dans la couche conductrice 2 permet un contact direct et une adhésion directe de cette dernière sur la couche substrat 1 sans qu'il soit nécessaire d'appliquer au préalable une couche d'adhésion supplémentaire sur ladite couche substrat 1. Cela permet alors une transmittance élevée car il y a absence d'une couche d'adhésion.

De plus la composition de la couche conductrice 2 permet, de par sa simplicité et de par l'utilisation d'un polymère adhésif (b) ayant une compatibilité chimique avec le polymère conducteur, d'avoir une électrode transparente conductrice multicouche avec un faible coefficient de haze et une rugosité également faible sans que cela ne nuise trop à la résistance de surface qui reste faible et ce même en l'absence de réseau de nanofilaments métalliques.

Cette électrode transparente conductrice multicouche, présente ainsi une transmittance élevée, un faible coefficient de haze et une rugosité également faible et ce pour un coût réduit car de composition plus simple et nécessitant moins d'étapes de fabrication.

**Revendications**

1. Electrode transparente conductrice multicouche, comportant :

   - une couche substrat (1),
   - une couche conductrice (2) comprenant au moins un polymère conducteur polythiophène éventuellement substitué, et au moins un polymère adhésif hydrophobe ayant une compatibilité chimique avec le polymère conducteur polythiophène éventuellement substitué,

   dans laquelle la couche conductrice (2) est en contact direct avec la couche substrat (1), **caractérisé en ce que** le polymère conducteur polythiophène éventuellement substitué présente une proportion en poids comprise entre 10 et 65 %, le polymère adhésif hydrophobe présente une proportion en poids comprise entre 20 et 90 % et ledit polymère adhésif hydrophobe a une compatibilité chimique avec le polymère conducteur polythiophène éventuellement substitué, de sorte que ladite électrode transparente conductrice multicouche ai un coefficient de haze inférieur ou égale à 3%.

2. Electrode transparente conductrice multicouche selon la revendication précédente, **caractérisée en ce que** la couche conductrice (2) comporte également au moins un polymère additionnel.

3. Electrode transparente conductrice multicouche selon la revendication précédente, **caractérisée en ce que** le polymère additionnel est du polyvinylpyrrolidone.

4. Electrode transparente conductrice multicouche selon l'une des revendications précédentes, **caractérisée en ce qu'**elle présente une transmittance moyenne sur le spectre visible supérieure ou égale à 75 %.

5. Electrode transparente conductrice multicouche selon l'une des revendications précédentes, **caractérisée en ce qu'**elle présente une rugosité inférieure à 20 nm.

6. Electrode transparente conductrice multicouche selon l'une des revendications précédentes, **caractérisé en ce qu'**elle présente une résistance de surface inférieure ou égale à 1000 Ω/☐ et supérieure ou égale à 50 Ω/☐.

7. Electrode transparente conductrice multicouche selon l'une des revendications précédentes, **caractérisée en ce que** le substrat (1) est choisi parmi, le verre et les polymères flexibles transparents.

8. Electrode transparente conductrice multicouche selon l'une des revendications précédentes, **caractérisée en ce que** le polymère adhésif hydrophobe comporte des fonctions ester en chaine latérale.

9. Electrode transparente conductrice multicouche selon la revendication précédente, **caractérisée en ce que** le polymère adhésif hydrophobe est choisi parmi les polyacétates de vinyle et les polyesters acryliques.

10. Procédé de fabrication d'une électrode transparente conductrice multicouche, comportant les étapes suivantes :

   - une étape (i) de réalisation d'une composition formant la couche conductrice (2) comportant :

      ◦ au moins un polymère conducteur polythiophène éventuellement substitué présentant une proportion en poids comprise entre 10 et 65 % après réticulation,
      ◦ au moins un polymère adhésif hydrophobe présentant une proportion en poids comprise entre 20 et 90 % après réticulation et ayant une compatibilité chimique avec le polymère conducteur polythiophène éventuellement substitué de sorte que ladite électrode transparente conductrice multicouche ai un coefficient de haze inférieur ou égale à 3%,

   - une étape (ii) d'application et de séchage de la composition formant la couche conductrice (2) directement sur la couche substrat (1),
   - une étape (iii) de réticulation thermique de la couche conductrice (2).

11. Procédé de fabrication d'une électrode transparente conductrice multicouche selon la revendication 10, **caractérisé en ce que** la composition formant la couche conductrice (2) comporte en outre au moins un polymère additionnel.

12. Procédé de fabrication d'une électrode transparente conductrice multicouche selon la revendication précédente, **caractérisé en ce que** le polymère additionnel est du polyvinylpyrrolidone.

13. Procédé de fabrication d'une électrode transparente conductrice multicouche selon l'une des revendications 10 à 12, **caractérisée en ce que** le substrat de la couche substrat (1) est choisi parmi, le verre et les polymères flexibles transparents.

14. Procédé de fabrication d'une électrode transparente conductrice multicouche selon l'une des revendications 10 à 13, **caractérisée en ce que** le polymère adhésif hydrophobe comporte des fonctions ester en chaine latérale.

15. Procédé de fabrication d'une électrode transparente conductrice multicouche selon la revendication précédente, **caractérisée en ce que** le polymère adhésif hydrophobe est choisi parmi les polyacétates de vinyle et les polyesters acryliques.

**Patentansprüche**

1. Transparente leitende mehrschichtige Elektrode, umfassend:

- eine Substratschicht (1),
- eine leitende Schicht (2), umfassend mindestens ein leitendes Polythiophenpolymer, welches gegebenenfalls substituiert ist, und mindestens ein hydrophobes haftendes Polymer, das eine chemische Kompatibilität mit dem leitenden Polythiophenpolymer, welches gegebenenfalls substituiert ist, aufweist,

wobei die leitende Schicht (2) in direktem Kontakt mit der Substratschicht (1) steht,
**dadurch gekennzeichnet, dass** das leitende Polythiophenpolymer, welches gegebenenfalls substituiert ist, einen Gewichtsanteil zwischen 10 und 65 % aufweist, das hydrophobe haftende Polymer einen Gewichtsanteil zwischen 20 und 90 % aufweist, und das hydrophobe haftende Polymer eine chemische Kompatibilität mit dem leitenden Polythiophenpolymer, welches gegebenenfalls substituiert ist, aufweist, so dass die transparente leitende mehrschichtige Elektrode einen Trübungskoeffizienten kleiner oder gleich 3 % aufweist.

2. Transparente leitende mehrschichtige Elektrode nach dem vorhergehenden Anspruch,
**dadurch gekennzeichnet, dass** die leitende Schicht (2) auch mindestens ein zusätzliches Polymer umfasst.

3. Transparente leitende mehrschichtige Elektrode nach dem vorhergehenden Anspruch,
**dadurch gekennzeichnet, dass** das zusätzliche Polymer Polyvinylpyrrolidon ist.

4. Transparente leitende mehrschichtige Elektrode nach einem der vorhergehenden Ansprüche,
**dadurch gekennzeichnet, dass** diese eine mittlere Transmittanz im sichtbaren Spektrum größer oder gleich 75 % aufweist.

5. Transparente leitende mehrschichtige Elektrode nach einem der vorhergehenden Ansprüche,
**dadurch gekennzeichnet, dass** diese eine Rauhigkeit kleiner 20 nm aufweist.

6. Transparente leitende mehrschichtige Elektrode nach einem der vorhergehenden Ansprüche,
**dadurch gekennzeichnet, dass** diese einen Oberflächenwiderstand kleiner oder gleich 1000 $\Omega/\square$ und größer oder gleich 50 $\Omega/\square$ aufweist.

7. Transparente leitende mehrschichtige Elektrode nach einem der vorhergehenden Ansprüche,
**dadurch gekennzeichnet, dass** das Substrat (1) aus Glas und flexiblen transparenten Polymeren ausgewählt ist.

8. Transparente leitende mehrschichtige Elektrode nach einem der vorhergehenden Ansprüche,
**dadurch gekennzeichnet, dass** das hydrophobe haftende Polymer Ester-Funktionen in der Seitenkette umfasst.

9. Transparente leitende mehrschichtige Elektrode nach dem vorhergehenden Anspruch,
**dadurch gekennzeichnet, dass** das hydrophobe haftende Polymer aus Vinylpolyacetaten und Acrylpolyestern ausgewählt ist.

10. Verfahren zur Herstellung einer transparenten leitenden mehrschichtigen Elektrode, umfassend die folgenden Schritte:

- einen Schritt (i) zur Herstellung einer Zusammensetzung, welche die leitende Schicht (2) bildet, umfassend:

  ∘ mindestens ein leitendes Polythiophen-Polymer, welches gegebenenfalls substituiert ist und einen Gewichtsanteil zwischen 10 und 65 % nach der Vernetzung aufweist,
  ∘ mindestens ein hydrophobes haftendes Polymer, das einen Gewichtsanteil zwischen 20 und 90 % nach der Vernetzung aufweist und eine chemische Kompatibilität mit dem leitenden Polythiophen-Polymer, welches gegebenenfalls substituiert ist, aufweist, so dass die transparente leitende mehrschichtige Elektrode einen Trübungskoeffizienten kleiner oder gleich 3 % aufweist,

- einen Schritt (ii) des Aufbringens und des Trocknens der Zusammensetzung, welche die leitende Schicht (2) bildet, direkt auf der Substratschicht (1),
- einen Schritt (iii) der thermischen Vernetzung der leitenden Schicht (2).

11. Verfahren zur Herstellung einer transparenten leitenden mehrschichtigen Elektrode nach Anspruch 10,
**dadurch gekennzeichnet, dass** die Zusammensetzung, welche die leitende Schicht (2) bildet, außerdem mindestens ein zusätzliches Polymer umfasst.

**12.** Verfahren zur Herstellung einer transparenten leitenden mehrschichtigen Elektrode nach dem vorhergehenden Anspruch,
**dadurch gekennzeichnet, dass** das zusätzliche Polymer Polyvinylpyrrolidon ist.

**13.** Verfahren zur Herstellung einer transparenten leitenden mehrschichtigen Elektrode nach einem der Ansprüche 10 bis 12,
**dadurch gekennzeichnet, dass** das Substrat der Substratschicht (1) aus Glas und flexiblen transparenten Polymeren ausgewählt wird.

**14.** Verfahren zur Herstellung einer transparenten leitenden mehrschichtigen Elektrode nach einem der Ansprüche 10 bis 13,
**dadurch gekennzeichnet, dass** das hydrophobe haftende Polymer Ester-Funktionen in der Seitenkette umfasst.

**15.** Verfahren zur Herstellung einer transparenten leitenden mehrschichtigen Elektrode nach dem vorhergehenden Anspruch,
**dadurch gekennzeichnet, dass** das hydrophobe haftende Polymer aus Vinylpolyacetaten und Acrylpolyestern ausgewählt wird.

**Claims**

**1.** Multilayer conductive transparent electrode comprising:

- a substrate layer (1),
- a conductive layer (2) comprising at least one optionally substituted polythiophene conductive polymer, and at least one hydrophobic adhesive polymer which has chemical compatibility with the optionally substituted polythiophene conductive polymer,

wherein the conductive layer (2) is in direct contact with the substrate layer (1), **characterized in that** the optionally substituted polythiophene conductive polymer has a weight proportion of between 10% and 65%, the hydrophobic adhesive polymer has a weight proportion of between 20% and 90% and said hydrophobic adhesive polymer has chemical compatibility with the optionally substituted polythiophene conductive polymer, such that said multilayer conductive transparent electrode has a coefficient of haze of less than or equal to 3%.

**2.** Multilayer conductive transparent electrode according to the preceding claim, **characterized in that** the conductive layer (2) also comprises at least one additional polymer.

**3.** Multilayer conductive transparent electrode according to the preceding claim, **characterized in that** the additional polymer is polyvinylpyrrolidone.

**4.** Multilayer conductive transparent electrode according to one of the preceding claims, **characterized in that** it has a mean transmittance in the visible spectrum of greater than or equal to 75%.

**5.** Multilayer conductive transparent electrode according to one of the preceding claims, **characterized in that** it has a roughness of less than 20 nm.

**6.** Multilayer conductive transparent electrode according to one of the preceding claims, **characterized in that** it has a surface resistance of less than or equal to 1000 $\Omega/\square$ and greater than or equal to 50 $\Omega/\square$.

**7.** Multilayer conductive transparent electrode according to one of the preceding claims, **characterized in that** the substrate (1) is chosen from glass and transparent flexible polymers.

**8.** Multilayer conductive transparent electrode according to one of the preceding claims, **characterized in that** the hydrophobic adhesive polymer comprises side-chain ester functions.

**9.** Multilayer conductive transparent electrode according to the preceding claim, **characterized in that** the hydrophobic adhesive polymer is chosen from polyvinyl acetates and acrylic polyesters.

**10.** Process for manufacturing a multilayer conductive transparent electrode, comprising the following steps:

- a step (i) of preparing a composition forming the conductive layer (2) comprising:

  ◦ at least one optionally substituted polythiophene conductive polymer which has a weight proportion of between 10% and 65% after crosslinking,
  ◦ at least one hydrophobic adhesive polymer which has a weight proportion of between 20% and 90% after crosslinking and which has chemical compatibility with the optionally substituted polythiophene conductive polymer such that said multilayer conductive transparent electrode has a coefficient of haze of less than or equal to 3%,

- a step (ii) of applying and drying the composition forming the conductive layer (2) directly on the substrate layer (1),
- a step (iii) of thermally crosslinking the conductive layer (2).

**11.** Process for manufacturing a multilayer conductive transparent electrode according to Claim 10, **characterized in that** the composition forming the conductive layer (2) also comprises at least one additional polymer.

**12.** Process for manufacturing a multilayer conductive transparent electrode according to the preceding claim, **characterized in that** the additional polymer is polyvinylpyrrolidone.

**13.** Process for manufacturing a multilayer conductive transparent electrode according to one of Claims 10 to 12, **characterized in that** the substrate of the substrate layer (1) is chosen from glass and transparent flexible polymers.

**14.** Process for manufacturing a multilayer conductive transparent electrode according to one of Claims 10 to 13, **characterized in that** the hydrophobic adhesive polymer comprises side-chain ester functions.

**15.** Process for manufacturing a multilayer conductive transparent electrode according to the preceding claim, **characterized in that** the hydrophobic adhesive polymer is chosen from polyvinyl acetates and acrylic polyesters.

2

1

Fig. 1

i

ii

iii

Fig. 2

Fig. 3A

Fig. 3B

## RÉFÉRENCES CITÉES DANS LA DESCRIPTION

**Documents brevets cités dans la description**

- US 2009129004 A
- WO 2011077804 A
- EP 2461649 A
- WO 2012124647 A
- US 2012138913 A
- US 2008237547 A
- WO 0106306 A

**Littérature non-brevet citée dans la description**

- **SUN et al.** *Progress in Organic Coatings,* 2007, vol. 59, 115-121
- **YIN et al.** *Journal of Materials Chemistry,* 2012, vol. 22, 3800